# EUROPEAN PATENT SPECIFICATION

(11) **EP 0 969 115 B1**
(45) Date of publication and mention of the grant of the patent: **12.01.2005**
(21) Application number: 97204158.6
(22) Date of filing: 05.05.1997
(51) Int. Cl.: C23C 4/00, C23C 14/24, C23C 14/30

(54) **Method of vacuum vaporization of metals**
Verfahren zur Vakuumbedampfung von Metallen
Procédé d'évaporation des métaux sous vide

(30) Priority: 17.05.1996 UA 96051932
(43) Date of publication of application: 05.01.2000
(73) Proprietor: UNITED TECHNOLOGIES CORPORATION, Hartford, CT 06101 (US); International Center For Paton Institute, Kiev-5, 252005 (UA)
(72) Inventor: Movchan, Boris B, 252004 Kiev (UA); Korth, Alexander V., 252033 Kiev (UA); Topal, Valery, 252098 Kiev (UA)
(74) Representative: Leckey, David Herbert

(56) References cited:
- US-A- 3 356 487
- US-A- 5 474 809
- PATENT ABSTRACTS OF JAPAN vol. 015, no. 478 (C-0891), 4 December 1991 (1991-12-04) & JP 03 207852 A (NKK CORP), 11 September 1991 (1991-09-11)
- PATENT ABSTRACTS OF JAPAN vol. 011, no. 200 (C-431), 27 June 1987 (1987-06-27) & JP 62 020865 A (MITSUBISHI HEAVY IND LTD), 29 January 1987 (1987-01-29)

## Description

### Technical field

The suggested invention concerns the vapor condensation of metals and complex alloys utilizing an electron beam. The invention particularly allows to vaporize, without any exclusion, all nickel and cobalt heat and corrosion resistant alloys, titanium alloys and others such as tool steel, aluminum and copper alloys.

The invention also offers an improvement of the vaporization process for any metal and alloy, complex or not, which allows to significantly increase the vaporization rate without any undesirable splashing of the metal.

### Previous technical level

The process of condensing coatings from vapors is widely known. This process is particularly used to obtain protective metal and ceramic coatings on gas turbine engine parts. The process is carried out in a vacuum and electron beam guns are normally used to melt the coating material and heat the melt to a temperature that is sufficient for vaporization at the required rate. The part to be coated is positioned over the melted metal puddle and the emanating vapors condense on the part and form the coating.

A number of studies have been conducted to increase the vaporization rate, but the problem still exists because the vaporization rate is too low from the point of view of the process effectiveness, and big problems also arise with the vaporization of the more complex alloys.

The common protective coating is considered to have the composition MCrAlY. In this formula M is the material selected from the following group: iron, cobalt and a nickel-cobalt mixture, Cr = chromium, Al = aluminum, and Y = yttrium with the composition of 5-40% Cr, 8-35% Al, 0.1-2% Y and the rest from the group of iron, nickel and a nickel-cobalt mixture. Coatings of this type are described in U.S. patents #3,676,085, #3,754,903 and #4,585,481.

The temperature of a material corresponding to the vapor pressure of 10⁻¹ Torr 1 Torr =̂ 133,3 Pa provides a sufficient vaporization rate for industrial applications under vacuum conditions. We will therefore call this temperature "vaporization temperature of the element". At the vapor pressure of 10⁻¹ Torr, the materials used for the protective coatings of the MCrAlY type have an approximate temperature of 1380°C for aluminum to 1715°C for cobalt (a range of 335°C). This relatively narrow range of vaporization temperatures for all the components of the MCrAlY alloy is of substantial significance for the concurrent vaporization of all components of the alloy and to produce the condensate with the required composition. The proximity of the vaporization temperatures of components translates into a close vaporization rates for all the materials.

The alloys containing elements with large differences in the vaporization temperatures exhibit a preferred vaporization of the material with the lowest vaporization temperature, so that the process resembles a fractional distillation. Returning to the Table 1 containing data for the doping elements of the superalloys, we can understand the problems of simultaneous vaporization of alloys containing for example aluminum and tungsten with very wide differences in the vaporization temperatures. If such an alloy is vaporized, the aluminum starts to vaporize first (at about 1380°C) leaving tungsten, which starts to evaporate only after the full vaporization of the aluminum, when the temperature of the metal puddle reaches the vaporization temperature of tungsten (about 3798°C).

This preferable vaporization means that the condensed coatings of alloy-containing components with wide differences in the vaporization temperatures will have a composition which differs substantially from the original alloy.

This restriction on the vaporization of the complex alloys limits the use of the vacuum vaporization method for complex alloys and structural superalloys. Structural superalloys usually contain refractory metals such as hafnium, niobium, molybdenum, tantalum, rhenium and tungsten, they also usually contain zirconium, boron and carbon. From the point of view of concurrent evaporation, all of these high vaporization temperature materials are incompatible with aluminum and chromium, which are considered necessary components of the nickel-based superalloys in their order.

This explains why it was not feasible until the present time to vaporize complex alloys containing components with vaporization temperatures that differ by more than 350°C from a metal puddle under vacuum.

This problem of the vaporization of complex alloys also prevents the vaporization of most titanium alloys which usually contain aluminum. Besides, the traditional method of vaporization generates a vaporization rate which is too low for the process to be considered economically competitive. The vaporization rate might be increased somewhat with a greater electron beam power, but this can lead to boiling and splashing of the material. The splashing can deposit drops on the surface of the coating parts and cause structural defects. The problem is therefore to increase the vaporization rate without any metal splashing from the melted puddle.

As was mentioned before, it did not seem possible until the present time to perform vacuum coating of complex alloys with doping components from a single source of vaporization when the range of the vaporization temperatures exceeded 350°C.

One of the attempts to overcome this difficulty consists in utilizing a number of melting crucibles, one for each group of alloy components with the same vaporization temperature. The crucibles are heated by separately controlled electron beam guns which allows to simultaneously deposit materials containing elements with various vaporization temperatures. However this method is very complex with the main difficulty being the control of individual vaporization rates of different components in order to obtain the required coating composition and its chemical homogeneity. Almost any point on the coating surface is closer to one crucible than to the other and will therefore have a higher concentration of the element which is evaporating from the closest melting crucible. This can lead to an unacceptable variation of the element concentration over the coating surface.

Some other methods were used in practice to create protective coatings, such as ion and plasma jet spraying and condensation under vacuum. In some cases plasma spraying can be an acceptable method for coatings with complex alloys, but it does not allow to obtain the same microstructure and density of the coating which the condensation under vacuum can produce. In most of the situations preference is therefore given to vapor condensation under vacuum.

The following method of vaporization of complex alloys to produce complex coatings is the closest to the described invention. It consists of manufacturing an ingot from the material to be vaporized, which has the shape and size that corresponds to the internal dimensions of the water-cooled copper crucible, then vertically advancing the ingot from lower part of the crucible to its upper part, use of the electron beam as the source of heat to create a melted metal puddle on the top of the ingot. This method is described in the book "High-temperature strength of nickel alloys and their protection from oxidation" (Kiev, Naukova Dumka, 1987, pages 196-200).

This method is not free of the above-mentioned deficiencies. The effective electron beam vaporization of the complex alloy requires a higher vaporization rate and therefore higher temperature of the melted metal puddle. This can be achieved by increasing the power of the electron beam used as the source of heat. However when the temperature increases the evaporating material starts to boil and the metal splashes. The flying drops of metal are deposited on the coating surface and cause defects. Therefore the power of the electron beam and consequently the vaporization rate of this method are usually not very high, the process of electron beam vaporization has low effectiveness, and most importantly slow evaporation of the initial complex alloys results in the selective evaporation of the alloy components and the composition of the deposited vapor coatings does not conform to the composition of the original alloy.

### Description of the invention

This invention was based on the task of creating a method of high-rate vaporization of metals and complex alloys containing components with vaporization temperatures ranging above 350°C, including: fabrication of the ingot for vaporization with the shape and size corresponding to the internal dimensions of a water-cooled copper melting crucible, vertical advance of the ingot from the lower part of the crucible to its upper part, use of an electron beam as the source of heat to create the melted metal puddle on top of the ingot, where the puddle is enriched by a refractory element, where the vaporization temperature is not less than that of the alloy component with the highest vaporization temperature, in this way creating the possibility to increase the power of the electron beam and the vaporization rate and avoid the metal splashing and the formation of coating defects. 67701.623

US-A-5,474,809 discloses a method for the high-rate vacuum vaporization of metals and alloys using an intermediary melted metal puddle, the method comprising:
preparation of an ingot for vaporization, the shape and size of the ingot corresponding to the internal dimensions of a water-cooled copper crucible;
vertical advance of the ingot upward from the lower to the upper part of the crucible;
utilization of an electron beam as a source of heat for melting a metal puddle on the upper part of the ingot;
the method further comprising the step for the high-rate vaporization of metals and complex alloys with a component vaporization temperature range over 350°C of
enrichment of the melted metal puddle by a refractory element with a vaporization temperature at least equal to that of the alloy component having the highest vaporization temperature.

The present invention is characterised over US-A-5,474,809 in that the enrichment of the melted metal puddle with the refractory element is carried out by adding the refractory element directly into the melted metal puddle.

It is preferable for the added enriching refractory element to have the vaporization temperature higher than that of the alloy component with the highest vaporization temperature, and so it is preferable to select the enriching refractory element from the following group: tungsten, hafnium, niobium, molybdenum, tantalum, rhenium, osmium, ruthenium, iridium and their mixtures. It is also preferable if the content of the refractory metal in the melting puddle is from 5% to 80% of the mass.

A more precise determination of the high limit of the enriching refractory element content in the puddle is as follows: the melted metal puddle may contain any amount of refractory additives, but up to the condition of complete or partial solidification for a given level of the applied heating power. Since the refractory additive has a high vaporization temperature, its vaporization rate will be zero in relation to the vaporization rates of the other alloy components in the melted metal puddle. The temperature of the puddle enriched with the refractory element can be increased to the level at which all the elements of the alloy will have a very high vaporization rate. One more advantage of the method of the invention is reduced boiling and splashing of the liquid metal in the puddle as compared to vaporization without the refractory additives, in order to increase the viscosity of the melt and increase the distance between the 'liquidus and solidus' curves of the alloy.

The invention can be understood with the help of a simple analogy. If one tries to evaporate a mixture of alcohol and water by heating the mixture, the alcohol will completely evaporate before water evens begins to evaporate, since it has a low temperature of evaporation. On the other hand if one tries to vaporize the alcohol and water mixture by dropping small amounts of the mixture on a well heated surface, the vaporization of the water and alcohol will be practically simultaneous. This represents the difference between the fractional distillation and the momentary vaporization.

This invention also allows the vaporization rate for any alloy to be significantly increased. The increased rate is caused by increasing the temperature of the puddle without any splashing. The increase in temperature before splashing could take place is made possible by the result of increased density and/or viscosity of the melt enriched by a refractory element, which prevents bubbles from forming and growing inside of the melted metal puddle.

Preferred embodiments of the invention will now be described, by way of example only, and with reference to the accompanying drawings in which:
Figure 1 represents the type of device normally used for electron beam coating the surface of the part with various coatings, which was used for the described invention.
Figure 2 represents a dependency of the thermal effectiveness and the deposit rate on the content of tungsten in the titanium based alloy.

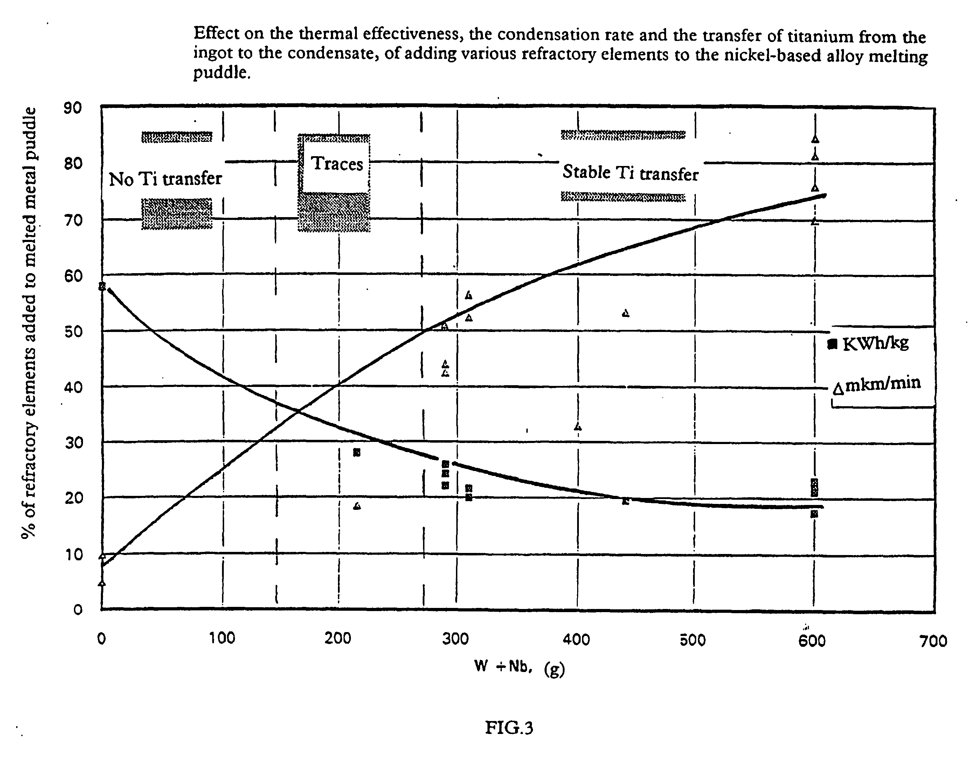

Figure 3 shows the effect on the thermal effectiveness, the condensation rate and the transfer of titanium from the ingot to the condensate, of adding various refractory elements to the nickel-based alloy melting puddle.

### Examples of the preferred realization of the invention

The present invention concerns the process of condensation of metals and complex alloys based on nickel, cobalt, iron, titanium, aluminum and copper. As mentioned earlier, we say "complex" of the alloys containing components with a difference of more than 350°C in the vaporization temperature, and preferably more than 500°C. The vaporization temperature is defined as the temperature at which the pressure of the alloy component vapor is above 10⁻¹ Torr. This means that in a vacuum of at least 10⁻⁴ Torr the complex alloy material will vaporize at a rate which allows the process to be applied in practice.

This method also allows to increase the vaporization rate significantly for all metals and alloys as well as increase the thermal effectiveness of the heating source, because the amount of energy required to vaporize the same amount of the alloy is reduced.

This result is achieved by the enrichment with the refractory element of the liquid melted metal puddle in which vaporization takes place. The refractory element is defined here as a metal in which both the melting and vaporization temperatures exceed 2000°C. This group includes the following: hafnium, niobium, molybdenum, tantalum, rhenium, ruthenium, tungsten and their mixtures. Osmium and iridium can also be used although they are very expensive and offer no significant advantage over other commonly used refractory elements.

The refractory element for the enrichment must be selected with regard to the final composite. For example this refractory element must have a vaporization temperature equal to or higher than the alloy component with the highest vaporization temperature. The melted metal puddle can therefore be enriched with titanium in order to vaporize the superalloy containing the element with the highest vaporization temperature, but it is preferable to enrich it with tungsten, niobium, molybdenum or hafnium.

The enrichment means no less than 5% and advisably no less than 10% of the selected refractory element. The upper limit of the enrichment is approximately 80% and more, but more precisely the solidification point of the melt.

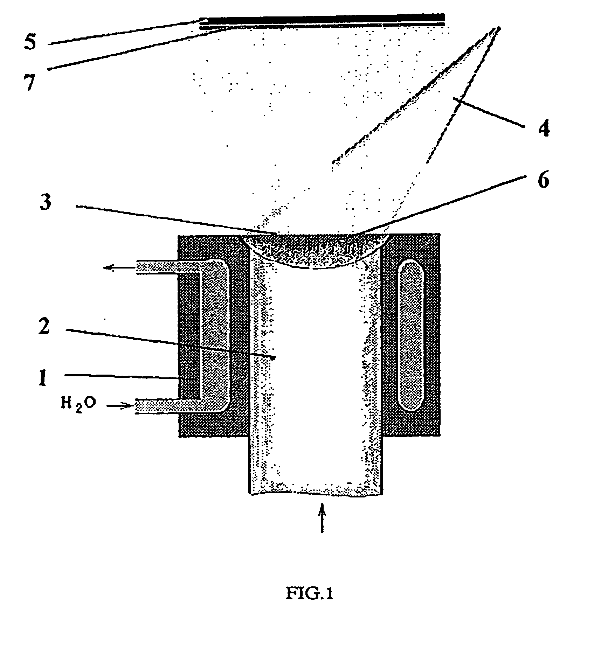

The invention is additionally clarified by the figures. The sketch in figure 1 represents the vaporization system utilized for various coating applications. The system consists of a water-cooled crucible 1 which is usually made of copper, and the ingot 2 made of the coating material to be deposited under vacuum. The ingot is advanced upward through the crucible 1 and its top surface 3 is heated by one or more of the electron beams 4. The part 5 to be coated is placed over the ingot and the vapors of the melted metal 6 on the top surface 3 of the ingot 2, which are generated by the heat of the electron beam 4, condense on its surface. The process is conducted under a high vacuum (at least 10⁻⁴ Torr).

This relatively simple system was used for a number of years to manufacture protective coatings on superalloy parts. However as mentioned before, this system cannot vaporize complex alloys and cannot offer a high deposition rate.

According to a preferred embodiment, the melted metal puddle 5 is enriched by a corresponding refractory element in amounts of 5% to 80%, preferably from 10% to 70%. Such additives enable the uniform vaporization of the complex alloys as well as a high vaporization rate of any metal and alloy in general. The vaporization rate increases particularly due to the significant increase in the temperature of the melted metal puddle. The thermal effectiveness also increases because the refractory element has a lower thermal conductivity and therefore less heat is transferred to the crucible walls. The increase in viscosity and density due to the refractory additives leads to the elimination of splashing.

A significant addition of the refractory material allows to heat the melting metal to a higher temperature, which enables to vaporize more refractory components of the original alloy ingot. In turn the higher temperature allows to increase the evaporation rate of the ingot material which is moving upward in the melted metal puddle by convection and diffusion, and appears in a state of vapor on the surface because the temperature increase causes an increase in the vapor pressure. As mentioned in the technical level section, the vaporization process of this invention is much closer to the momentary evaporation than to the fractional distillation.

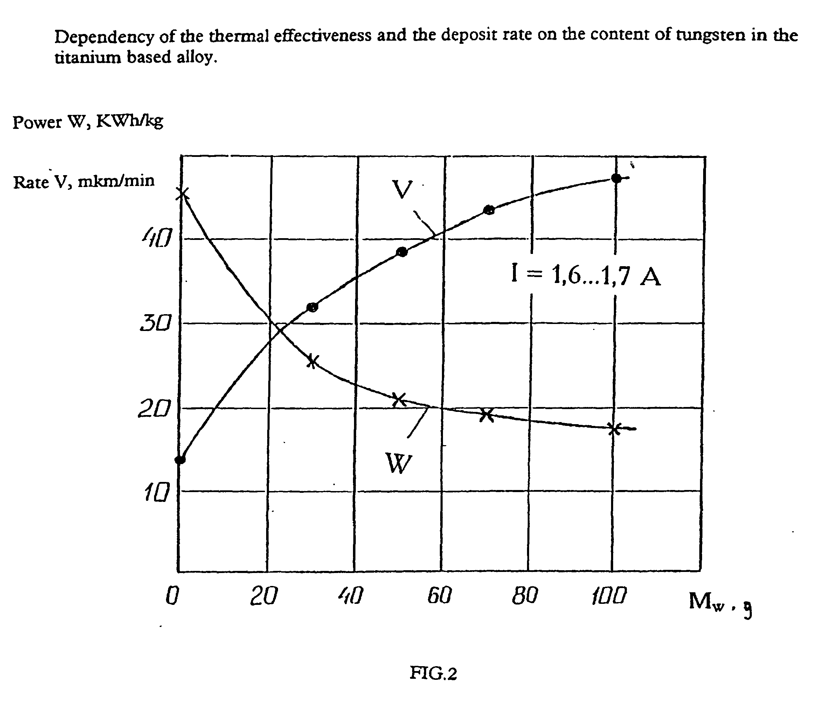

Figure 2 shows the effect of adding tungsten as the refractory element on the vaporization rate and on the thermal effectiveness of the condensation process for the titanium-based alloy containing 5% Al and 2.5% Sn. Similar vaporization results were obtained with some other refractory materials and alloys.

The invention is illustrated by the following examples.

### Example 1.

An alloy with a nominal composition of 20% Cr, 4.5% Al, 3.5% Ti, 0.1% Y and the balance of nickel was produced by electron beam vaporization and condensation using the device pictured in figure 1. A variety of refractory materials was added to the melted metal puddle. The main problem was the transfer of titanium with a vaporization temperature of 1950°C.

The difference in the vaporization temperatures (at 10⁻¹ Torr) for aluminum and titanium is 570°C, thus justifying the title of "complex alloy".

The addition of refractory elements allows significant increases to the rate (and the effectiveness) of the material vaporization. It can also be seen that the mixture of tungsten and niobium promotes the transfer of titanium, which is not found with the enrichment by just one of these metals.

The coating rate increased 500% while the electron beam power was only 60% more, which provides a significant improvement in the effectiveness when the new invention is applied.

### Example 2.

In this example the titanium-based alloy, which is also considered a "complex alloy", was selected for the vaporization:

| **Element** | **Content %** | **Vaporization temperature (°C) at a vapor pressure of 10**^{**-1**} **Torr** |
|---|---|---|
| Titanium | Base | 1950 |
| Aluminum | 5 | 1380 |
| Tin | 2.5 | 1405 |

In the experiment, different amounts of tungsten were added to the melted metal puddle. The results are shown in figure 2. The data show the increase in effectiveness caused by the application of the invention. The chemical composition based on Ti with 4.1 - 4.4% Al and 2.5% Sn is the typical chemical composition of the condensate to demonstrate the ability of the proposed invention to obtain condensed coatings of the titanium-based alloys.

The refractory element used to enrich the melted metal puddle can be placed on the top surface of the alloy ingot and melted concurrently with the alloy material. In our opinion the refractory material should be added gradually, not at once. Some other ways of adding the refractory materials can be used. For example, a powder blank made of the mixture of the alloy components and the refractory material can be prepared. Similarly the upper part of the ingot can consist of metal discs with alternating layers of the refractory material and the alloy with the corresponding thicknesses selected to ensure the desired degree of enrichment.

As soon as the enrichment of the melted metal puddle has taken place once, the process does not need any further additives for normal operation, since at the alloy evaporation temperature the refractory element will not evaporate at any noticeable rate and its quantity will practically not be reduced over time. Under normal conditions of the process, the vapor pressure of the refractory element is 1,000 to 10,000 times less than the vapor pressure of the alloy elements.

As can be seen in figure 1, in practice new ingots are usually advanced upward and become shorter as the vaporization proceeds, and in this way one step of enriching the melted metal puddle with the refractory element allows to vaporize a number of ingots.

We have detected that the addition of the refractory elements increases the vaporization rate 2 to 5 times and thereby also the deposit rate and at that time the consumed power is reduced. It is also known from the analysis of the previous technical level that the fast vaporization of even non-complex alloys (within the 350°C range of the alloy component vaporization temperatures) without increasing the heating power, which inevitably leads to splashing of the melted metal puddle. An increase in the vaporization rate is required from the economical point of view. The suggested invention allows to increase the vaporization rate by 2 to 5 times and to obtain alloy coatings from the condensate complex (with the vaporization temperature range above 500°C) as the result of the increase of the melted metal puddle temperature via the enrichment of the melt by the addition of the refractory elements.

A noticeable increase and the elimination of the metal splashing were also observed.

## Claims

1. A method for the high-rate vacuum vaporization of metals and alloys using an intermediary melted metal puddle (6), the method comprising:
preparation of an ingot (2) for vaporization, the shape and size of the ingot corresponding to the internal dimensions of a water-cooled copper crucible (1);
vertical advance of the ingot (2) upward from the lower to the upper part of the crucible (1);
utilization of an electron beam (4) as a source of heat for melting a metal puddle (6) on the upper part (3) of the ingot (2);
the method further comprising the step for the high-rate vaporization of metals and complex alloys with a component vaporization temperature range over 350°C of
enrichment of the melted metal puddle (6) by a refractory element with a vaporization temperature at least equal to that of the alloy component having the highest vaporization temperature,
**characterised in that** the enrichment of the melted metal puddle (6) with the refractory element is carried out by adding the refractory element directly into the melted metal puddle (6).

2. A method as claimed in claim 1, wherein the vaporization temperature of the refractory element is higher than that of the alloy component having the highest vaporization temperature.

3. A method as claimed in claim 1 or 2, wherein the content of the refractory element in the melted metal puddle (6) is from 5% to 80% of the mass.

4. A method as claimed in any preceding claim, wherein the refractory element is selected from the following group: tungsten, hafnium, niobium, molybdenum, tantalum, rhenium, osmium, ruthenium, iridium and their mixtures.

## Patentansprüche

1. Verfahren für die Vakuumverdampfung hoher Rate von Metallen und Legierungen mittels einer vermittelnden, geschmolzenen Metalllache (6), wobei das Verfahren aufweist:
Bereitstellen einen Ingots (2) zur Verdampfung, wobei die Form und Größe des Ingots den Innenabmessungen eines wassergekühlten Kupfertiegels (1) entsprechen;
vertikales Vorschieben des Ingots (2) nach oben von dem unteren zu dem oberen Teil des Tiegels (1);
Verwenden eines Elektronenstrahls (4) als eine Wärmequelle zum Schmelzen einer Metalllache (6) an dem oberen Teil (3) des Ingots (2);
wobei das Verfahren ferner den Schritt des Verdampfens hoher Rate von Metallen und komplexen Legierungen mit einem Komponentenverdampfungstemperaturbereich von über 350 °C aufweist;
Anreichern der geschmolzenen Metalllache (6) durch ein hoch schmelzendes Element mit einer Verdampfungstemperatur, die zumindest gleich derjenigen der Legierungskomponente mit der höchsten Verdampfungstemperatur ist,
**dadurch gekennzeichnet, dass** das Anreichern der geschmolzenen Metalllache (6) mit dem hoch schmelzenden Element durch Zugeben des hoch schmelzenden Elements direkt in die geschmolzene Metalllache (6) durchgeführt wird.

2. Verfahren nach Anspruch 1, wobei die Verdampfungstemperatur des hoch schmelzenden Elements höher ist als diejenige der Legierungskomponente mit der höchsten Verdampfungstemperatur.

3. Verfahren nach Anspruch 1 oder 2, wobei der Gehalt des hoch schmelzenden Elements in der geschmolzenen Metalllache (6) von 5 % bis 80 % der Masse ist.

4. Verfahren nach einem der vorangehenden Ansprüche, wobei das hoch schmelzende Element aus der nachfolgenden Gruppe ausgewählt ist: Wolfram, Hafnium, Niob, Molybdän, Tantal, Rhenium, Osmium, Ruthenium, Iridium und deren Mischungen.

## Revendications

1. Procédé de vaporisation sous vide à haut rendement de métaux et alliages utilisant une flaque de métal fondu intermédiaire (6), le procédé comprenant :
la préparation d'un lingot (2) pour la vaporisation, la forme et la taille du lingot correspondant aux dimensions internes d'un creuset en cuivre refroidi à l'eau (1) ;
l'avancée verticale du lingot (2) vers le haut à partir de la partie inférieure jusqu'à la partie supérieure du creuset (1) ;
l'utilisation d'un faisceau d'électrons (4) comme source de chaleur pour faire fondre une flaque de métal (6) sur la partie supérieure (3) du lingot (2) ;
le procédé comprenant en outre l'étape, pour la vaporisation à haut rendement de métaux et alliages complexes avec une plage de températures de vaporisation du composant supérieure à 350°C,
d'enrichissement de la flaque de métal fondu (6) par un élément réfractaire avec une température de vaporisation au moins égale à celle du composant d'alliage ayant la température de vaporisation la plus élevée,
**caractérisé en ce que** l'enrichissement de la flaque de métal fondu (6) avec l'élément réfractaire est réalisé en ajoutant l'élément réfractaire directement à la flaque de métal fondu (6).

2. Procédé selon la revendication 1, dans lequel la température de vaporisation de l'élément réfractaire est supérieure à celle du composant de l'alliage ayant la température de vaporisation la plus élevée.

3. Procédé selon la revendication 1 ou 2, dans lequel la teneur en élément réfractaire de la flaque de métal fondu (6) est de 5 % à 80 % de la masse.

4. Procédé selon l'une quelconque des revendications précédentes, dans lequel l'élément réfractaire est choisi dans le groupe suivant : tungstène, hafnium, niobium, molybdène, tantale, rhénium, osmium, ruthénium, iridium et leurs mélanges.
